# EUROPEAN PATENT APPLICATION

(11) **EP 4 386 402 A1**
(43) Date of publication of application: **19.06.2024**
(21) Application number: 23156687.8
(22) Date of filing: 15.02.2023
(51) Int. Cl.: G01R 31/367, G01R 31/389, G01R 31/396

(54) **BATTERY DEVICE, DETECTION METHOD THEREOF, BATTERY CELL SCREENING METHOD AND DEVICE**

(30) Priority: 15.12.2022 CN 202211612448
(71) Applicant: CALB Co., Ltd., Changzhou City, Jiangsu Province (CN)
(72) Inventor: PI, Ting, Changzhou City; Jiangsu Province (CN); GAO, Po, Changzhou City; Jiangsu Province (CN); MA, Ruijun, Changzhou City; Jiangsu Province (CN)
(74) Representative: Becker, Eberhard

(57) **Abstract**

The disclosure discloses a battery device, a detection method thereof, a screening method and a screening device for a battery cell. The feature value is determined according to the peak width parameter of one of the peaks in the DRT spectrum, so based on the feature value, it is possible to reflect the difference in the relaxation time corresponding to the electrochemical process in different battery cells, and then reflect the difference in health and performance of different battery cells. In this manner, when performing screening based on the above condition, it is possible to screen battery cells with consistent health and performance, so that the consistency of the screened battery cells is better, and the performance of the battery assembly formed is excellent.

## Description

### BACKGROUND

### Technical Field

The disclosure relates to the field of battery technology, in particular to a battery device, a detection method thereof, a screening method and a screening device for a battery cell.

### Description of Related Art

During the preparation process of single cells, due to the differences between batches of materials and the limitations of battery manufacturing processes such as slurry mixing, coating, and rolling, even if the single cells produced in the same batch, it is inevitable that there will be differences in the consistency of single cells caused by the manufacturing process, which leads to differences between the individual single cells produced. If these single cells are directly assembled, there will be differences between the battery assemblies. As a result, the consistency between the single cells in the battery assemblies is poor. Therefore, before the batteries are assembled, they will be screened for battery consistency to select single cells with better consistency for assembling.

In the related art, generally single cells with good consistency in indicators such as battery voltage, internal resistance, and capacity are selected for assembling. However, after the single cells have just been produced, the single cells with good consistency screened out through the battery voltage, internal resistance, capacity and other indicators will generally be stored for a period of time after being assembled into a battery assembly and before the battery is loaded for shipping. This storage process generally ranges from a few months to as long as a year. During this storage process, a series of electrochemical changes will spontaneously occur inside the single cells, making the consistency between the single cells worse again.

Therefore, it is a technical problem to be solved urgently by those skilled in the art to provide a battery assembly so that the single cells still have good consistency after a period of storage.

### SUMMARY

The embodiment of the present disclosure provides a battery device, a detection method thereof, a screening method and a screening device for a battery cell, which are provided to improve the consistency among the individual single cells in the battery module, and the single cells still have good consistency after a period of storage.

In a first aspect, an embodiment of the present disclosure provides a battery device, including a plurality of battery cells, and the difference between the feature values of any two battery cells in the same state of charge is within 10%. The feature value of any battery cell in any state of charge is determined in the following method: performing an electrochemical impedance test on the battery cell in the state of charge, and after performing DRT processing on the obtained test data to obtain a DRT spectrum, determining the feature value of the battery cell in the state of charge according to the peak width parameter of one of the peaks in the DRT spectrum, where the peak width parameters include: peak width and/or half-peak width.

In the second aspect, an embodiment of the present disclosure provides a battery cell screening method, including: determining the feature value of each of a plurality of battery cells to be selected in the same state of charge; where the feature value of any of the battery cells in any state of charge is determined in the following method: performing an electrochemical impedance test on the battery cell in the state of charge, and after performing DRT processing on the obtained test data to obtain a DRT spectrum, determining the feature value of the battery cell in the state of charge according to the peak width parameter of one of the peaks in the DRT spectrum; calculating the difference between the feature values of any two battery cells; and selecting the battery cell whose difference is within a preset range.

In a third aspect, an embodiment of the present disclosure provides a detection method for a battery device, where the battery device includes a plurality of battery cells; the detection method includes: determining the feature value of each of the battery cells in the current state of charge; where the feature value of any of the battery cells in any state of charge is determined in the following method: performing an electrochemical impedance test on the battery cell in the state of charge, and after performing DRT processing on the obtained test data to obtain a DRT spectrum, determining the feature value of the battery cell in the state of charge according to the peak width parameter of one of the peaks in the DRT spectrum; calculating the difference between the feature values of any two battery cells; and determining the consistency of the battery device based on the difference.

In a fourth aspect, an embodiment of the present disclosure provides a battery cell screening device, including: a memory, which is configured to store program instructions; a processor, which is configured to invoke the program instructions stored in the memory, and execute the above-mentioned screening method provided by the embodiment of the present disclosure according to the obtained program.

In a fifth aspect, an embodiment of the present disclosure provides a detection device for a battery device, including: a memory, which is configured to store program instructions; a processor, which is configured to invoke the program instructions stored in the memory, and execute the above-mentioned detection method provided by the embodiment of the present disclosure according to the obtained program.

The advantageous effects of the present disclosure are as follows:

The battery device, the detection method thereof, the battery cell screening method and the device provided in the embodiments of the present disclosure have the following advantages:

First, the feature value is determined according to the peak width parameter of one of the peaks in the DRT spectrum, so based on the feature value, it is possible to reflect the difference in the relaxation time corresponding to the electrochemical process in different battery cells, and then reflect the difference in health and performance of different battery cells. In this manner, when performing screening based on the above condition, it is possible to screen battery cells with consistent health and performance, so that the consistency of the screened battery cells is better, and the performance of the battery assembly formed is excellent.

Second, the battery assemblies screened in this way still have good consistency after storage, the consistency between battery cells will not deteriorate after a certain period of storage, so that the battery device may have better performance.

Third, this solution may dynamically monitor the consistency of each battery cell in the battery device, which may reflect the consistency of the battery cell during use, and realize the on-line monitoring of the battery cell, thus providing a guide for the subsequent use of the battery device.

### BRIEF DESCRIPTION OF THE DRAWINGS

For a better understanding of the disclosure, reference may be made to exemplary embodiments shown in the following drawings. The components in the drawings are not necessarily to scale and related elements may be omitted, or in some instances proportions may have been exaggerated, so as to emphasize and clearly illustrate the features described herein. In addition, related elements or components can be variously arranged, as known in the art. Further, in the drawings, like reference numerals designate same or like parts throughout the several views.
FIG. 1 is a flowchart of a battery cell screening method provided in an embodiment of the present disclosure.
FIG. 2 is a DRT spectrum provided in an embodiment of the present disclosure.
FIG. 3 is another DRT spectrum provided in an embodiment of the present disclosure.
FIG. 4 is a flowchart of a detection method for a battery device provided in an embodiment of the present disclosure.
FIG. 5 is a schematic structural diagram of a battery cell screening device provided in an embodiment of the present disclosure.
FIG. 6 is a schematic structural diagram of a detection device for a battery device provided in an embodiment of the present disclosure.

### DESCRIPTION OF THE EMBODIMENTS

The technical solutions in the exemplary embodiments of the disclosure will be described clearly and explicitly in conjunction with the drawings in the exemplary embodiments of the disclosure. The description proposed herein is just the exemplary embodiments for the purpose of illustrations only, not intended to limit the scope of the disclosure, so it should be understood that and various modifications and variations could be made thereto without departing from the scope of the disclosure.

In the description of the present disclosure, unless otherwise specifically defined and limited, the terms "first", "second" and the like are only used for illustrative purposes and are not to be construed as expressing or implying a relative importance. The term "plurality" is two or more. The term "and/or" includes any and all combinations of one or more of the associated listed items.

Specific implementations of a battery device, a detection method thereof, a screening method and a screening device for a battery cell provided by the embodiments of the present disclosure will be described in detail below with reference to the accompanying drawings. It should be noted that the described embodiments are only some of the embodiments of the present disclosure, but not all of the embodiments. Based on the embodiments of the present disclosure, all other embodiments obtained by persons of ordinary skill in the art without making creative efforts belong to the protection scope of the present disclosure.

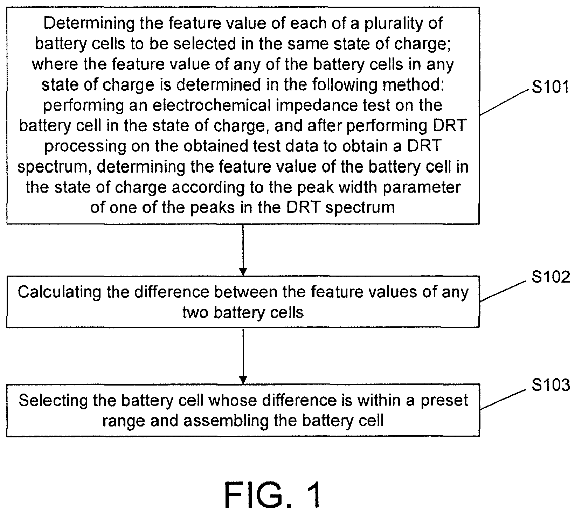

An embodiment of the present disclosure provides a battery cell screening method, as shown in FIG. 1, including: S101, determining the feature value of each of a plurality of battery cells to be selected in the same state of charge; where the feature value of any of the battery cells in any state of charge is determined in the following method: performing an electrochemical impedance test on the battery cell in the state of charge, and after performing DRT processing on the obtained test data to obtain a DRT spectrum, determining the feature value of the battery cell in the state of charge according to the peak width parameter of one of the peaks in the DRT spectrum; where the peak width parameters include: peak width and/or half-peak width, it should be understood that DRT is a relaxation time distribution technique; S102, calculating the difference between the feature values of any two battery cells; S103, selecting the battery cell whose difference is within a preset range and assembling the battery cell.

Inside the battery cell, the relaxation time corresponding to the electrochemical reaction process is related to the resistance and capacitance of the battery cell, where the relaxation time is represented by τ, the resistance value is represented by R, and the capacitance value is represented by C, τ=R^{∗}C. When the resistance and capacitance values are fixed, the relaxation time corresponding to the electrochemical reaction process is also a fixed value. When the frequency is represented by f, f=1/τ, so when the relaxation time corresponding to the electrochemical reaction process is a fixed value, the frequency corresponding to the electrochemical reaction process is also fixed, and the peak width parameter corresponding to the frequency may also be considered to be fixed.

Based on this, if different battery cells are inconsistent in design parameters (including but not limited to NP ratio, areal density of active materials, compacted density of active materials, porosity, degree of infiltration, etc.) and/or process defects are introduced, there will be different relaxation times corresponding to the electrochemical reaction process of different battery cells, and therefore the peak width parameters corresponding to the electrochemical reaction process will be different.

When the feature value is determined according to the peak width parameter of one of the peaks in the DRT spectrum, based on the feature value, it is possible to reflect the difference in the relaxation time corresponding to the electrochemical process in different battery cells, and then reflect the difference in health and performance of different battery cells. In this manner, when performing screening based on the above condition, it is possible to screen battery cells with consistent health and performance, so that the consistency of the screened battery cells is better, and the performance of the battery assembly formed is excellent.

Moreover, the battery assemblies screened in this way still have good consistency after storage, the consistency between battery cells will not deteriorate after a certain period of storage, so that the battery device may have better performance.

In some embodiments, the preset range may be but not limited to 10%, that is, the difference between the feature values of any two battery cells in the screened battery cells is within 10%. Further, the preset range may be but not limited to 5%, which may further reduce the difference between feature values, and further reduce the difference between various battery cells, which helps to further improve the consistency of the screened battery cells.

The following takes a certain battery cell as an example to describe the process of determining the feature value of the battery cell.

The determination process of determining the feature value of the battery cell when the state of charge is a is taken as an example for illustration. The determination process specifically includes the following:

Step 1. An electrochemical impedance test is performed on a battery cell with a charge state of a to obtain test data.

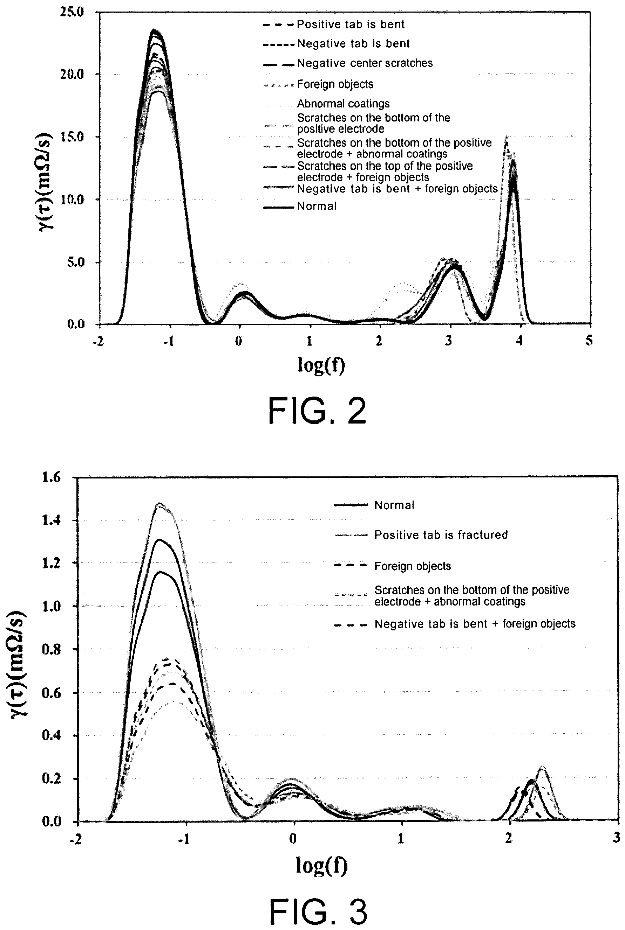

Step 2. DRT processing is performed on the test data to obtain a DRT spectrum; where, the DRT spectrum may be shown in FIG. 2, the abscissa is the logarithm of the frequency f, and the ordinate is the intensity.

In the obtained DRT spectrum, each curve may include multiple (two or more) peaks, and each peak may represent an impedance. For example, in FIG. 2, for a curve, the six peaks are marked in sequence as: P1, P2, P3, P4, P5 and P6, and the peak P1 represents the solid phase diffusion resistance (expressed as Rd-s), the peak P2 represents liquid phase diffusion resistance (expressed as Rd-1), the peak P3 represents negative electrode charge transfer impedance (expressed as Rct-n), the peak P4 represents positive electrode charge transfer impedance (expressed as Rct-p), the peak P5 represents membrane impedance (expressed as Rsei), and the peak P6 represents the contact impedance (expressed as Rc).

Of course, in actual situations, the number of peaks included in each curve in the DRT spectrum is not limited to 6, which may be less than 6, or more than 6, and needs to be determined according to actual needs, and the disclosure provides no limitation thereto.

Step 3. The feature value of the battery cell in the state of charge a is determined according to the peak width parameter of one of the peaks in the DRT spectrum.

In some embodiments, performing step 3 may include: determining the feature value of the battery cell (such as battery cell) in the state of charge (such as state of charge a) according to the peak width parameter of the peak corresponding to the positive electrode charge transfer impedance in the DRT spectrum or the peak width parameter of the peak corresponding to the negative electrode charge transfer impedance in the DRT spectrum.

For example, as shown in FIG. 2, the feature value of the battery cell in the state of charge may be determined based on the peak width parameter of peak P4 or peak P3 in the DRT spectrum.

Since the positive electrode charge transfer impedance and negative electrode charge transfer impedance are affected by changes in solid phase diffusion impedance, liquid phase diffusion impedance, membrane impedance, and contact impedance, while changes in positive electrode charge transfer impedance and negative electrode charge transfer impedance may not cause change of solid phase diffusion impedance, liquid phase diffusion impedance, membrane impedance and contact impedance change, so no matter when the problem of battery aging or electrode sheeting manufacturing is occurred, the deviation of the peak width parameter corresponding to the positive electrode charge transfer impedance and the negative electrode charge transfer impedance is the most obvious. Therefore, when determining the feature value based on the peak width parameters corresponding to the positive electrode charge transfer impedance and the negative electrode charge transfer impedance, the sensitivity of the screening may be effectively improved, the influence of errors may be reduced, and the consistency of the screened battery cells is better, which may effectively improve the performance of the assembled battery device.

Of course, in actual situations, it is not limited to determine the feature value based on the peak width parameters of peak P4 or peak P3, the feature value may also be determined based on the peak width parameters of peak P1, peak P2, peak P5 or peak P6, which may be determined according to the actual situation and the disclosure is not limited thereto, so as to satisfy the needs of different application scenarios.

in some embodiments, when performing step 3, the operation may include: using the peak width parameter of one of the peaks in the DRT spectrum as the feature value of the battery cell in the state of charge a; alternatively, after performing calculation processing on the peak width parameter of one of the peaks in the DRT spectrum, using the result of the calculation processing as the feature value of the battery cell in the state of charge a; where the calculation processing includes: normalization processing, etc.

In this way, the feature value may be determined based on the peak width parameter of one of the peaks in the DRT spectrum, so as to facilitate subsequent screening of battery cells based on the feature value.

In some embodiments, when the peak width parameter is peak width, the method for determining the peak width in the DRT spectrum includes:

### Method 1:

For any peak, the distance between the tangent line drawn at the inflection points on both sides of the peak and the intersection point of the abscissa is the peak width, which may also be called the tangent peak width.

### Method 2:

When one of the peaks is the initial peak among the multiple peaks included in the DRT spectrum, the first frequency value is determined according to the intersection point between the initial peak and the abscissa of the DRT spectrum, and the second frequency value is determined according to the frequency inflection point between the initial peak and the non-initial peak; the difference between the second frequency value and the first frequency value is used as the peak width of the initial peak.

When one of the peaks is the terminating peak in multiple peaks, the first frequency value is determined according to the frequency inflection point between the terminating peak and the non-terminating peak, and the second frequency value is determined according to the intersection point between the terminating peak and the abscissa; the difference between the second frequency value and the first frequency value is used as the peak width of the terminating peak.

When one of the peaks is an intermediate peak in multiple peaks except the initial peak and the terminating peak, the first frequency value is determined according to the frequency inflection point between the intermediate peak and the adjacent peak on one side of the intermediate peak, and the second frequency value is determined according to the intermediate peak and the adjacent peak on the other side of the intermediate peak; the difference between the second frequency value and the first frequency value is taken as the peak width of the intermediate peak.

For example, continuing to show in FIG. 2, assuming that only 6 peaks are included in each curve, then:
Peak P1 is the initial peak, so the first frequency value of peak P1 is determined according to the intersection point between peak P1 and the abscissa. Since there are two intersection points, the smaller value of the two intersection points may be selected as the first frequency value at this time. For example, -1.8 is used as the first frequency value; the second frequency value of peak P1 is determined according to the frequency inflection point between peak P1 and peak P2. Assuming that the logarithm of the frequency inflection point is -0.4, the second frequency value of peak P1 may be is -0.4. At this time -0.4-(-1.8)=1.4, that is, the peak width of peak P1 is 1.4.
Peak P6 is the terminating peak, so the second frequency value of peak P6 is determined according to the intersection point between peak P6 and the abscissa. Since there are two intersection points, the larger value of the two intersection points may be selected as the second frequency value at this time, for example, 4.2 is taken as the second frequency value. Assuming that the logarithm of the frequency inflection point between peak P6 and peak P5 is 3.4, the first frequency value of peak P6 may be 3.4, and at this time 4.2-3.4=0.8, that is, the peak width of peak P6 is 0.8.
Peak P2, peak P3, peak P4, and peak P5 are intermediate peaks. Taking peak P2 as an example, the logarithm of the frequency inflection point between peak P2 and peak P1 is assumed to be -0.4, and the logarithm of the frequency inflection point between peak P2 and peak P3 is assumed to be 0.55, at this time 0.55-(-0.4)=0.95, that is, the peak width of peak P2 is 0.9. Similarly, the determination process of the peak width of peak P3, peak P4 and peak P5 is the same as that of peak P2, and no more examples are given here.

In this way, no matter which peak in the DRT spectrum serves as the basis when determining the feature value, the peak width of the peak may be determined, so as to facilitate to determine the feature value in subsequent process.

In some embodiments, when the peak width parameter is the half-peak width, the method for determining the half-peak width in the DRT spectrum includes: as a straight line parallel to the abscissa through the midpoint of the peak height, the distance between the straight line and the two points on both sides of the peak is the half-peak width.

In some embodiments, the feature value is determined based on the peak width parameter of one of the peaks in the DRT spectrum. However, in actual situations, in addition to this method, the feature value may also be determined based on the peak width parameter of multiple peaks in the DRT spectrum, such as but not limited to: taking the peak width parameter as the half-peak width as an example, finding the half-peak width of peaks P3 and peak P4 in the DRT spectrum, and then determining the feature value based on the ratio of the two half-peak widths, or determining the feature value based on the difference between the two half-peak widths. Of course, the peaks P3 and P4 only serve as examples for illustration here, and the number of peaks and the type of impedance corresponding to the peaks may be selected according to actual conditions, which are not limited here.

In some embodiments, when screening batteries, in addition to the methods given in S101 to S103 above, the following methods may also be used for screening: selecting a reference battery cell, the reference battery cell may be charged and discharged for less than 10 times (of course, charging and discharging are not limited to 10 times, and may also be 5 times, which may be set according to the strictness of screening); determining the feature value of the reference battery cell in a certain state of charge, and defining the determined feature value as the reference feature value; among the plurality of battery cells to be selected, selecting the battery cells whose difference between feature value in the same state of charge and the reference feature value is within a preset range, and assembling the selected battery cell.

Since the reference battery cell is a fresh battery with excellent battery performance, this battery cell may be used as a reference to select a battery cell whose feature value is relatively close to the reference feature value, so that the performance of the selected battery cell is not only relatively close to the reference battery cell, but also has an improved performance, so that the performance of the assembled battery device is better.

The following will be described in conjunction with specific embodiments.

Example: Take a soft pack battery, of which the peak width parameter is the peak width, and the screening is based on the reference battery cell as an example. The DRT spectrum is shown in FIG. 2.

When the difference of feature value is within 10% as an example, for battery cells with different problems, the peak width of each peak and the peak width of the corresponding peak in the reference battery cell are shown in Table 1.

When the preset range is 10%, the corresponding range of peak P1 is 1.26-1.54, the corresponding range of peak P2 is 0.855-1.045, the corresponding range of peak P3 is 0.675-0.825, and the corresponding range of peak P4 is 1.17-1.43, the corresponding range of peak P5 is 0.63-0.77, and the corresponding range of peak P6 is 0.72-0.88.

In Table 1 below, the problems of battery cell 1 to battery cell 17 are as follows:
Positive tabs are bent in battery cells 1 and 2, negative tabs are bent in battery cells 3 and 4, scratches are found on the negative electrode sheet in battery cells 5 and 6, foreign objects are found in battery cells 7 and 8, there is coating abnormality on the surface of the negative electrode sheet in battery cells 9 and 10, scratches are found on the bottom of the positive electrode in battery cell 11, scratches are found on the bottom of the positive electrode and there is coating abnormality on the surface of the negative electrode sheet in battery cells 12 and 13, scratches are found on the top of the positive electrode and foreign matter is found in battery cells 14 and 15, negative tabs are bent and foreign matter is found in battery cells 16 and 17.

As can be seen from the following Table 1 and FIG. 2:
When the battery cell has problems such as tab bending, foreign objects, scratches, and abnormal coatings, the peak widths of peak P3 (representing the negative electrode charge transfer impedance) and peak P4 (representing the positive electrode charge transfer impedance) are substantially outside the corresponding range.

Therefore, comparing each battery cell with the reference battery cell, it can be found that the peak width of the peak P3 and peak P4 of the battery cell with certain problems is quite different from the peak width of the peak P3 and peak P4 of the reference battery cell. Therefore, when screening is performed based on the peak widths of peaks P3 and P4, battery cells with high consistency may be accurately screened out, and the screening results have high accuracy and low error.

**Table 1**

| Peak width | P1 | P2 | P3 | P4 | P5 | P6 |
|---|---|---|---|---|---|---|
| Reference battery cell | 1.40 | 0.95 | 0.75 | 1.30 | 0.70 | 0.80 |
| Battery cell 1 | 1.41 | 0.95 | 0.76 | 0.58 | 1.56 | 0.74 |
| Battery cell 2 | 1.40 | 0.91 | 0.87 | 0.73 | 1.33 | 0.76 |
| Battery cell 3 | 1.41 | 0.91 | 0.93 | 0.77 | 1.23 | 0.75 |
| Battery cell 4 | 1.41 | 0.92 | 0.87 | 0.80 | 1.12 | 0.88 |
| Battery cell 5 | 1.39 | 0.89 | 0.93 | 0.83 | 1.15 | 0.77 |
| Battery cell 6 | 1.39 | 0.90 | 0.93 | 0.81 | 1.16 | 0.77 |
| Battery cell 7 | 1.42 | 0.91 | 0.87 | 0.80 | 1.11 | 0.89 |
| Battery cell 8 | 1.41 | 0.82 | 0.86 | 0.92 | 1.14 | 0.89 |
| Battery cell 9 | 1.37 | 0.98 | 1.02 | 1.09 | 0.79 | 0.75 |
| Battery cell 10 | 1.36 | 0.96 | 1.03 | 0.97 | 0.81 | 0.87 |
| Battery cell 11 | 1.40 | 0.90 | 0.88 | 0.62 | 1.46 | 0.74 |
| Battery cell 12 | 1.41 | 0.93 | 0.95 | 0.67 | 1.28 | 0.69 |
| Battery cell 13 | 1.41 | 0.95 | 0.92 | 0.82 | 1.14 | 0.69 |
| Battery cell 14 | 1.42 | 0.93 | 0.91 | 0.71 | 1.27 | 0.76 |
| Battery cell 15 | 1.42 | 0.91 | 0.92 | 0.72 | 1.27 | 0.76 |
| Battery cell 16 | 1.41 | 0.89 | 0.91 | 0.78 | 1.26 | 0.75 |
| Battery cell 17 | 1.40 | 0.96 | 0.93 | 0.16 | 0.82 | 0.73 |

Example: Take a hard housing battery, of which the peak width parameter is the peak width, and the screening is performed based on the reference battery cell as an example. The DRT spectrum is shown in FIG. 3.

When the difference of feature value is within 10% as an example, for the reference battery cell and the battery cell with different problems, the peak widths of various peaks and the peak width of the corresponding peak in the reference battery cell are as shown in Table 2 below.

**Table 2**

| Peak width | P1 | P2 | P4 | P6 |
|---|---|---|---|---|
| Reference battery cell 1 | 1.36 | 0.96 | 0.94 | 0.56 |
| Reference battery cell 2 | 1.36 | 0.96 | 0.93 | 0.56 |
| Battery cell 1 | 1.36 | 1.00 | 1.19 | 0.60 |
| Battery cell 2 | 1.36 | 1.00 | 1.24 | 0.60 |
| Battery cell 3 | 1.36 | 0.97 | 1.11 | 0.48 |
| Battery cell 4 | 1.36 | 0.98 | 1.10 | 0.47 |
| Battery cell 5 | 1.36 | 0.98 | 1.19 | 0.51 |
| Battery cell 6 | 1.33 | 0.98 | 1.32 | 0.53 |
| Battery cell 7 | 1.36 | 0.97 | 1.10 | 0.50 |

When the preset range is 10%, the corresponding range of peak P1 is 1.224-1.496, the corresponding range of peak P2 is 0.864-1.056, the corresponding range of peak P4 is 0.846-1.034, and the corresponding range of peak P6 is 0.504-0.616.

In Table 2 above, the problems of battery cell 1 to battery cell 7 are as follows:
Positive tabs are bent in battery cells 1 and 2, foreign objects are found in battery cells 3 and 4, scratches are found on the bottom of the positive electrode and there is coating abnormality on the surface of the negative electrode sheet in battery cells 5 and 6, negative tabs are bent and foreign matter is found in battery cell 7.

It can be seen from the above Table 2 and FIG. 3 that:
When the preset range is 10%, the peak widths of peak P1 and peak P2 from battery cell 1 to battery cell 7 are all within the corresponding range, and the peak widths of peak P4 from battery cell 1 to battery cell 7 are all outside the corresponding range, and the peak width of peak P6 of battery cell 3 and battery cell 4 is outside the corresponding range.

Therefore, comparing various battery cells with the reference battery cell, it can be found that the peak width of the peak P4 of the battery cell with certain problems is quite different from the peak width of the peak P4 of the reference battery cell. Therefore, when screening is performed based on the peak width of the peak P4, battery cells with high consistency may be accurately screened out, and the screening results have high accuracy and low error.

To illustrate further, in FIG. 3, each curve only shows four peaks, but this does not mean that only these four peaks are included in the DRT spectrum corresponding to the battery cell. It's just that in this embodiment, only the data of these four peaks are shown in the data obtained after battery cell 1 to battery cell 7 are tested.

Based on the same inventive concept, an embodiment of the present disclosure provides a battery device, including a plurality of battery cells, and the difference in feature value of any two battery cells in the same state of charge is within 10%.

The feature value of any battery cell in any state of charge is determined in the following way: performing an electrochemical impedance test on the battery cell in the state of charge, and after performing DRT processing on the obtained test data to obtain a DRT spectrum, determining the feature value of the battery cell in the state of charge according to the peak width parameter of one of the peaks in the DRT spectrum, the peak width parameters include: peak width and/or half-peak width.

The number of battery cells included in the battery device may be set according to actual needs, and is not limited here.

In this way, the feature value is determined according to the peak width parameter of one of the peaks in the DRT spectrum, so based on the feature value, it is possible to reflect the difference in the relaxation time corresponding to the electrochemical process in different battery cells, and further reflect the difference in health and performance of the different battery cells. In this manner, when performing screening based on the above condition, it is possible to screen battery cells with consistent health and performance, so that the consistency of the screened battery cells is better, and the performance of the battery assembly formed is excellent.

In some embodiments, the difference in feature value of any two battery cells in the same state of charge is within 5%.

In this way, the difference of the feature value of any two battery cells may be further reduced, and then the difference of the relaxation time corresponding to the electrochemical process in different battery cells may be further reduced, so that the performance and health of various battery cells are closer, thereby further improving performance of the battery device.

In some embodiments, the feature value of any battery cell in any state of charge is: the peak width parameter of the peak corresponding to the positive electrode charge transfer impedance in the DRT spectrum or the peak width parameter of the peak corresponding to the negative electrode charge transfer impedance in the DRT spectrum.

In some embodiments, for the method for determining the feature value, reference may be made to the related content given in the foregoing screening method, and details are not described here again.

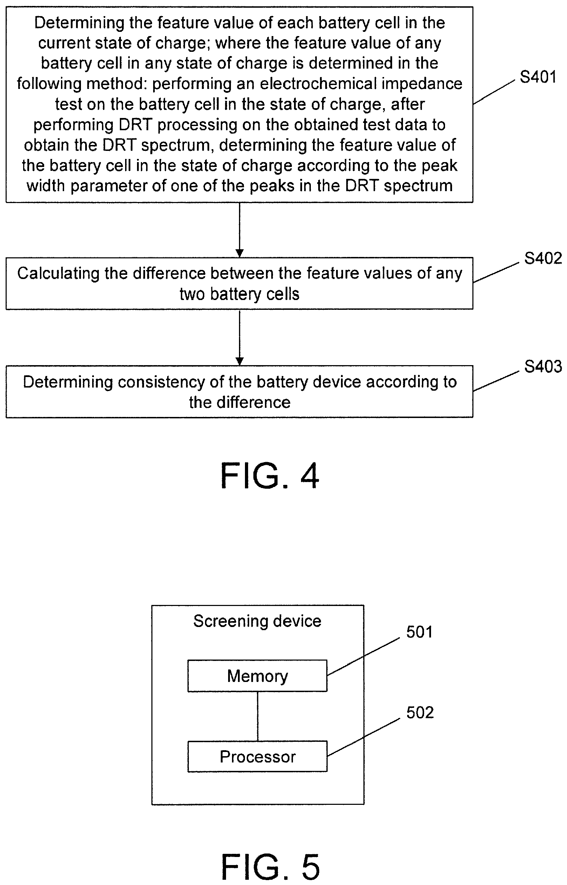

Based on the same inventive concept, an embodiment of the present disclosure provides a detection method for a battery device. As shown in FIG. 4, the battery device includes multiple battery cells; the detection method includes: S401. determining the feature value of each battery cell in the current state of charge; where the feature value of any battery cell in any state of charge is determined in the following method: performing an electrochemical impedance test on the battery cell in the state of charge, after performing DRT processing on the obtained test data to obtain the DRT spectrum, determining the feature value of the battery cell in the state of charge according to the peak width parameter of one of the peaks in the DRT spectrum; in some embodiments, for the method for determining the feature value, reference may be made to the related content given in the foregoing screening method, and details are not described here again; S402. calculating the difference between the feature values of any two battery cells; S403. determining consistency of the battery device according to the difference.

In this way, it is possible to dynamically monitor the consistency of each battery cell in the battery device, which may reflect the consistency of the battery cell during use, and realize the on-line monitoring of the battery cell, thus providing a guide for the subsequent use of the battery device.

In some embodiments, in order to realize the above step S403, the operation specifically includes: determining the maximum value of all differences; determining the consistency level corresponding to the difference range where the maximum value falls within according to the correspondence between the preset difference range and the consistency level.

For example, assume that in the correspondence between the difference range and the consistency level, the consistency level corresponding to the difference range [c1, c2) is excellent, the consistency level corresponding to the difference range [c2, c3) is good, and the consistency level corresponding to the difference range [c3, c4) is poor, then:
If the difference range of the determined maximum value is [c2, c3), it means that the consistency level of the battery device is medium, indicating that the performance and service life of the battery device are average.

If the difference range of the determined maximum value is [c1, c2), it means that the consistency level of the battery device is excellent, indicating that the performance and service life of the battery device are good.

If the difference range of the determined maximum value is [c3, c4), it means that the consistency level of the battery device is poor, indicating that the performance and service life of the battery device are poor.

Of course, the corresponding relationship between the difference range and the consistency level is not limited to the relationship listed above. Here, the above-mentioned relationship is used as an example for illustration. In actual situations, the corresponding relationship between the preset difference range and consistency level may be set according to actual needs and is not limited here.

In this way, the consistency of the battery device may be determined based on the maximum value of all the differences and the correspondence between the difference range and the consistency level, providing a reference for the use of the battery device.

Of course, in some embodiments, in addition to determining the consistency of the battery device based on the maximum value of all differences, the operation may also include: calculating the mean of all differences, and determining the consistency level corresponding to the difference range where the mean falls within.

In this way, the differences of all battery cells may be reflected, and the consistency of the battery device may be judged comprehensively.

In some embodiments, the battery device is a battery pack, and the battery cell is a battery module or a battery assembly.

Or, when the battery device is a battery pack or a battery module, the battery cell is a single cell.

Or, when the battery device is a container battery system, the battery cell is a battery pack.

In this way, this detection method may judge the consistency difference of the container battery system, battery pack, and battery module (or battery assembly) at three levels, and has a wide range of application fields and higher utility.

In some embodiments, early warning, display, and recording may also be performed based on the determined consistency of the battery device, providing data reference for subsequent improvement and analysis of battery performance, providing users with more intuitive data, allowing users to pay attention to the performance changes of the battery device, and prepare in advance for the occurrence of danger, so as to improve the safety of the battery device during use.

Based on the same inventive concept, an embodiment of the present disclosure provides a battery cell screening device. The realization principle of the screening device is similar to that of the aforementioned screening method. For specific embodiments of the screening device, please refer to the specific implementation of the aforementioned screening method, and repetitions are omitted.

Specifically, a battery cell screening device provided in an embodiment of the present disclosure, as shown in FIG. 5, includes: a memory 501, which is configured to store program instructions; a processor 502, which is configured to invoke the program instructions stored in the memory 501, and execute the above-mentioned screening method as provided by the embodiment of the present disclosure according to the obtained program.

Based on the same inventive concept, an embodiment of the present disclosure provides a detection device for a battery device. The realization principle of the detection device is similar to that of the detection method described above. For the specific embodiment of the detection device, please refer to the specific implementation of the detection method described above, and repetitions are omitted.

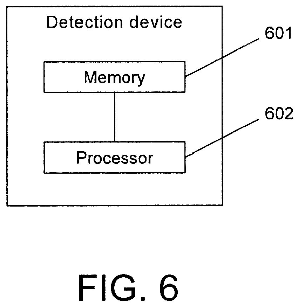

Specifically, a detection device for a battery device provided in an embodiment of the present disclosure, as shown in FIG. 6, includes: a memory 601, which is configured to store program instructions; a processor 602, which is configured to invoke the program instructions stored in the memory 601, and execute the above-mentioned screening method as provided by the embodiment of the present disclosure according to the obtained program.

In some embodiments, the detection device may be a module in the battery management system, and the module may be an existing module in the battery management system, or may be a newly added module in the battery management system, as long as the detection function may be integrated in the battery management system.

It should be emphasized that the above-mentioned technical solution provided by the embodiment of the present disclosure uses the peak width (or half-peak width) of one of the peaks in the DRT spectrum to determine the feature value of the battery cell, which may reflect the relaxation time corresponding to the electrochemical reaction process that occurs in the battery cell, based on which, when performing screening or detection on battery cells, it is possible to accurately, quickly and effectively screen out batteries with better consistency, and detect the differences between battery cells. In this way, not only that the screening of battery cells may be realized, but also online monitoring and judgment on the consistency of the assembled battery devices may be performed, so as to determine the current performance of the battery devices and provide data reference for users' utilization.

The battery assemblies screened in this way still have good consistency after storage, the consistency between battery cells will not deteriorate after a certain period of storage. This solution may dynamically monitor the consistency of each battery cell in the battery device, which may reflect the consistency of the battery cell during use, and realize the on-line monitoring of the battery cell, thus providing a guide for the subsequent use of the battery device.

Obviously, those skilled in the art can make various changes and modifications to the present disclosure without departing from the spirit and scope of the present disclosure. Thus, if these modifications and variations of the present disclosure fall within the scope of the claims of the present disclosure and their equivalent technologies, the present disclosure also intends to include these modifications and variations.

Other embodiments of the disclosure will be apparent to those skilled in the art from consideration of the specification and practice of the disclosure disclosed herein. The disclosure is intended to cover any variations, uses or adaptations of the disclosure. These variations, uses, or adaptations follow the general principles of the disclosure and include common general knowledge or conventional technical means in the art that are not disclosed in the present disclosure. The specification and embodiments are illustrative, and the real scope and spirit of the present disclosure is defined by the appended claims.

## Claims

1. A battery device, **characterized by** comprising a plurality of battery cells, wherein a difference between feature values of any two of the battery cells in the same state of charge is within 10%;
wherein the feature value of any of the battery cells in any state of charge is determined in the following method:
performing an electrochemical impedance test on the battery cell in the state of charge, and after performing DRT processing on an obtained test data to obtain a DRT spectrum, determining the feature value of the battery cell in the state of charge according to a peak width parameter of one of peaks in the DRT spectrum (5101), wherein the peak width parameter comprises: a peak width and/or a half-peak width.

2. The battery device according to claim 1, wherein the difference between the feature values of any two of the battery cells in the same state of charge is within 5% (S102).

3. The battery device according to claim 1, wherein the feature value of any of the battery cells in any state of charge is a peak width parameter of a peak corresponding to a positive electrode charge transfer impedance in the DRT spectrum or a peak width parameter of a peak corresponding to a negative electrode charge transfer impedance in the DRT spectrum.

4. A screening method of a battery cell, **characterized by** comprising:
determining a feature value of each of a plurality of battery cells to be selected in the same state of charge; wherein the feature value of any of the battery cells in any state of charge is determined in the following method: performing an electrochemical impedance test on the battery cell in the state of charge, and after performing DRT processing on an obtained test data to obtain a DRT spectrum, determining the feature value of the battery cell in the state of charge according to a peak width parameter of one of peaks in the DRT spectrum (S101);
calculating a difference between the feature values of any two of the battery cells (S102); and
selecting the battery cell whose difference is within a preset range (S103).

5. The screening method according to claim 4, wherein the step of determining the feature value of the battery cell in the state of charge according to the peak width parameter of the one of the peaks in the DRT spectrum comprises:
determining the feature value of the battery cell in the state of charge according to a peak width parameter of a peak corresponding to a positive electrode charge transfer impedance in the DRT spectrum or a peak width parameter of a peak corresponding to a negative electrode charge transfer impedance in the DRT spectrum.

6. The screening method according to claim 4 or 5, wherein when the peak width parameter is a peak width, the method for determining the peak width of the one of the peaks in the DRT spectrum comprises:
when the one of the peaks is an initial peak among a plurality of peaks comprised in the DRT spectrum, a first frequency value is determined according to an intersection point between the initial peak and a abscissa of the DRT spectrum, and a second frequency value is determined according to a frequency inflection point between the initial peak and a non-initial peak; a difference between the second frequency value and the first frequency value is used as a peak width of the initial peak;
when the one of the peaks is a terminating peak in the plurality of peaks, the first frequency value is determined according to a frequency inflection point between the terminating peak and a non-terminating peak, and the second frequency value is determined according to an intersection point between the terminating peak and the abscissa; a difference between the second frequency value and the first frequency value is used as a peak width of the terminating peak;
when the one of the peaks is an intermediate peak in the plurality of peaks except the initial peak and the terminating peak, the first frequency value is determined according to a frequency inflection point between the intermediate peak and an adjacent peak on one side of the intermediate peak, and the second frequency value is determined according to the intermediate peak and an adjacent peak on the other side of the intermediate peak; a difference between the second frequency value and the first frequency value is taken as a peak width of the intermediate peak.

7. A detection method for a battery device, **characterized in that** the battery device comprises a plurality of battery cells; and the detection method comprising:
determining a feature value of each of the battery cells in a current state of charge; wherein the feature value of any of the battery cells in any state of charge is determined in the following method: performing an electrochemical impedance test on the battery cell in the state of charge, and after performing DRT processing on an obtained test data to obtain a DRT spectrum, determining the feature value of the battery cell in the state of charge according to a peak width parameter of one of peaks in the DRT spectrum (S401);
calculating a difference between the feature values of any two of the battery cells (S402); and
determining a consistency of the battery device based on the difference (S403).

8. The detection method according to claim 7, wherein the step of determining the consistency of the battery device according to the difference comprises:
determining a maximum value of all of the differences;
determining a consistency level corresponding to a difference range where the maximum value falls within according to a correspondence between a preset difference range and a consistency level.

9. A screening device for a battery cell, comprising:
a memory (501), which is configured to store program instructions;
a processor (502), which is configured to invoke the program instructions stored in the memory, and execute the screening method as claimed in any one of claims 4-6 according to an obtained program.

10. A detection device for a battery device, comprising:
a memory (601), which is configured to store program instructions;
a processor (602), which is configured to invoke the program instructions stored in the memory, and execute the detection method as claimed in claim 7 or 8 according to an obtained program.
